# EUROPEAN PATENT APPLICATION

(11) **EP 0 470 780 A2**
(43) Date of publication of application: **12.02.1992**
(21) Application number: 91307134.6
(22) Date of filing: 02.08.1991
(51) Int. Cl.: H04L 12/56, H04Q 3/68

(54) **Improved growable switch**

(30) Priority: 09.08.1990 US 565008
(71) Applicant: AT&T Corp., New York, NY 10013-2412 (US)
(72) Inventor: Eng, Kai Y., Eatontown, NJ 07724 (US); Karol, Mark J., Fair Haven, NJ 07704 (US)
(74) Representative: Watts, Christopher Malcolm Kelway

(57) **Abstract**

An LED pulse shaping circuit (10) capable of providing improved rise time (using current peaking) and fall time (using charge extraction) comprises a conventional differential current switch (12, 14, 16) coupled to a pair of switching elements (24,26) and resistance elements (20,22). A first switching element (24) is activated at the beginning of a pulse to provide an initially increased drive current to the LED, depending on the value of a first resistance element (20). The current peaking thus decreases the rise time of the LED. The remaining switching element (26) and resistance (22) are utilized, in conjunction with the differential current switch, to provide a reverse current flow through the LED at the end of the pulse. The charge extraction thus decreases the fall time of the LED.

## Description

### Background of the Invention

### Field of the Invention

The present invention relates to an LED pulse shaping circuit and, more particularly, to a variable switched circuit capable of improving both the rise time and fall time of an LED.

### Description of the Prior Art

The LED has emerged as a promising optical source for applications such as local area networks (LANs), computer networks, and interoffice communication systems which are less than about 3 km in length. Interest in utilizing LEDs is primarily due to their lower cost versus laser-based alternatives. For example, employing high power LEDs in transmitters greatly relaxes the alignment tolerances for the optical assembly which coupled the LED to the communication fiber. Unfortunately, high power LEDs, especially long wavelength devices, are usually unsuitable for high speed applications (i.e., > 100 Mb/s) due to their relatively slow rise and fall times (typically >3 ns).

U.S. Patent 4,166,947, issued to J. P. Dirksen on September 4, 1979 is illustrative of the conventional techniques used to improve the fall time of LEDs. Dirksen discloses resistive shunting of an LED in response to a turn-off signal to provide a low impedance path for the elimination of the minority carriers in the device. An alternative arrangement is disclosed in U.S. Patent 4,295,226 issued to L. C. Dombrowski on October 13, 1981. Dombrowski discloses a driver circuit arranged to bias the LED so as to draw current during either its ON or OFF state. The arrangement allows for the effective overdriving of current through the LED in the reverse, or negative direction. This overdriving of the LED aids the sweeping of minority carriers out of the junction region and thereby improves the fall time of the LED optical output. However, since the LED draws current during both the ON and OFF states, different levels of optical output will exist in each state, requiring additional threshold detection circuitry to determine the state of the device.

Thus, a need remains in the art for a pulse shaping circuit which is capable of improving both the rise and fall times of LEDs while overcoming the limitations of the prior art arrangements.

### Summary of the Invention

The need remaining in the prior art is addressed by the present invention which relates to an LED pulse shaping circuit and, more particularly, to a switched circuit capable of providing both current peaking and charge extraction.

In accordance with one embodiment of the present invention, a conventional differential current switch driver circuit for an LED is modified to include a pulse shaping circuit comprising first means for providing a current peak of a predetermined value to the LED on the rising edge of a pulse (to decrease the LED rise time) and second means for providing a reverse current to the LED at the end of the pulse (to decrease the LED fall time). A preferred pulse shaping circuit utilizes a transistor and resistor pair to form each means. By controlling when the transistors turn ON and OFF, in concert with the operation of the differential current switch driver circuit, pulse shaping is achieved.

It is an advantage of the present invention that the degree of pulse shaping may be easily controlled by utilizing variable resistors and adjusting their values and/or the timing of the delay between the activation of the pair of pulse shaping transistors. Further, the variable resistor values may be adjusted to tailor the current peaking and charge extraction abilities to the characteristics of the particular LED coupled to the pulse shaping circuit.

Other and further advantages of the present invention will become apparent during the course of the following discussion and by reference to the accompanying drawings.

### Brief Description of the Drawing

Referring now to the drawings:
FIG. 1 illustrates an exemplary switched bridge pulse shaping circuit of the present invention;
FIG. 2 contains a simplified diagram of the LED drive current generated by the circuit of FIG. 1;
FIG. 3 illustrates an output pulse of a long wavelength LED, without any pulse shaping; and
FIG. 4 illustrates, by way of comparison, an output pulse of a long wavelength LED coupled to an exemplary pulse shaping circuit of the present invention.

### Detailed Description

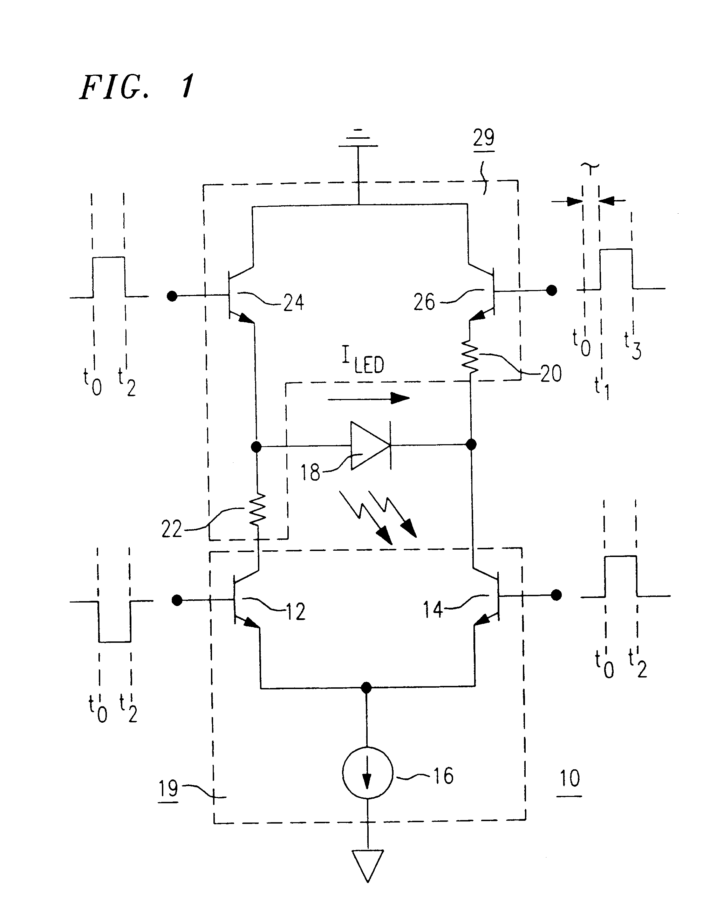

FIG. 1 illustrates an exemplary pulse shaping circuit 10 formed in accordance with the teachings of the present invention. As shown, circuit 10 includes a first pair of transistors 12,14 and current source 16 coupled as shown to an LED 18 so as to form a conventional differential current switch 19 therewith. A pair of resistors 20 and 22 are utilized as current limiting devices at the terminals of LED 18. A second pair of transistors 24,26 function, as described in detail below, to steer the current through LED 18 so as to provide either current peaking or charge extraction. The combination of transistors 24,26 with variable resistors 20,22 thus form the pulse shaping portion 29 of circuit 10.

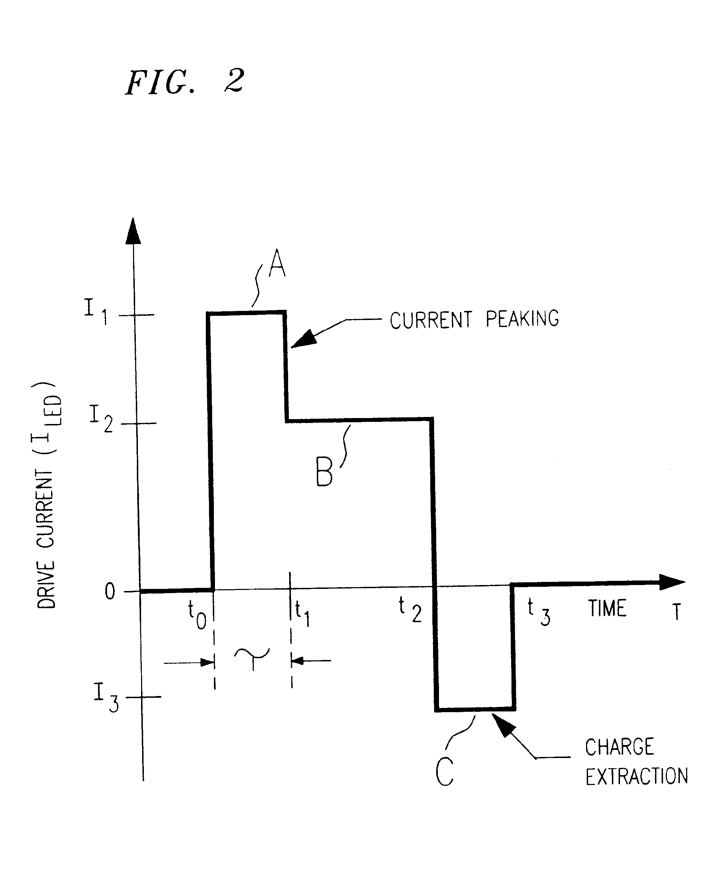

The operation of circuit 10 may be understood by reference to FIG. 2, which illustrates the ideal LED drive current as a function of time. In particular, LED 18 (FiG. 1) turns ON at time to when a forward current path is created by switching ON transistors 24 and 14, while maintaining transistors 26 and 12 OFF, indicated by the letter A in FIG. 2. At this point in time, current I_{LED} through LED 18 is at the initial increased current peaking level 1₁, as shown in FIG. 2. After a predetermined delay τ (τ = t₁ - to), transistor 26 switches ON, bringing transistor 14 closer to saturation, thus reducing the level of drive current I_{LED} to the value 1₂, indicated by the letter B in FIG. 2. The level of 1₂ is determined in circuit 10 of FIG. 1 by the value of resistor 20. At the completion of the bit period (time t₂), transistors 24 and 14 are switched OFF, while transistor 12 is turned ON. Since transistor 26 remains ON, a reverse current path is created from transistor 26 through transistor 12, drawing a current LED of value 1₃ in the reverse direction through LED 18, as indicated by the letter C in FIG. 2. The level of reverse current 1₃ is determined by the value of resistor 22. Finally, at time t₃ transistor 26 is turned OFF and LED drive current I_{LED} is returned to the zero (or other suitable reference) level.

Referring to FIG. 2, section A of the LED drive current can be referred to as the current peaking portion, and section C as the charge extraction portion. As discussed above, the values of 1₁ and 1₃ associated with current peaking and charge extraction, respectfully, are controlled by adjusting the values of resistors 20 and 22, respectively. Typical values for 1₁ and 1₂ may fall within the ranges of 100-120 mA and 60-80 mA, respectively. Reverse current 1₃ may typically fall within the same range as 1₂. Additionally, varying the delay τ will also modify the performance of circuit 10. Therefore, the circuit arrangement of the present invention may be tailored to adjust to a specific application (e.g., only current peaking, only charge extraction, both peaking and extraction to varying degrees), or to the performance levels of individual LED devices, since each device may exhibit slightly different characteristics. It is to be noted that the utilization of an extremely short delay t (for example, < 1 ns) will produce no pulse shaping effect, whereas too long a delay (for example, > 3 ns) will allow the LED junction to eventually become reverse-biased, a condition which may degrade device reliability. The length of the delay is further limited by the system bit rate. For example, in a 200 Mb/s system, each pulse is 5 ns in duration. Therefore, the delay must be less than 5 ns so that the circuit will be able to respond in time to the next data pulse. Additionally, the values ofresistors 20,22 may be limited by the available voltage range. In other words, drive currents 1₁ and 1₃ may not exceed certain limits as determined by the voltage headroom of the system. In most applications, however, resistors 20,22 will be rather small and the drive current rather low, thus allowing for sufficient voltage headroom to provide the desired amount of current peaking and/or charge extraction.

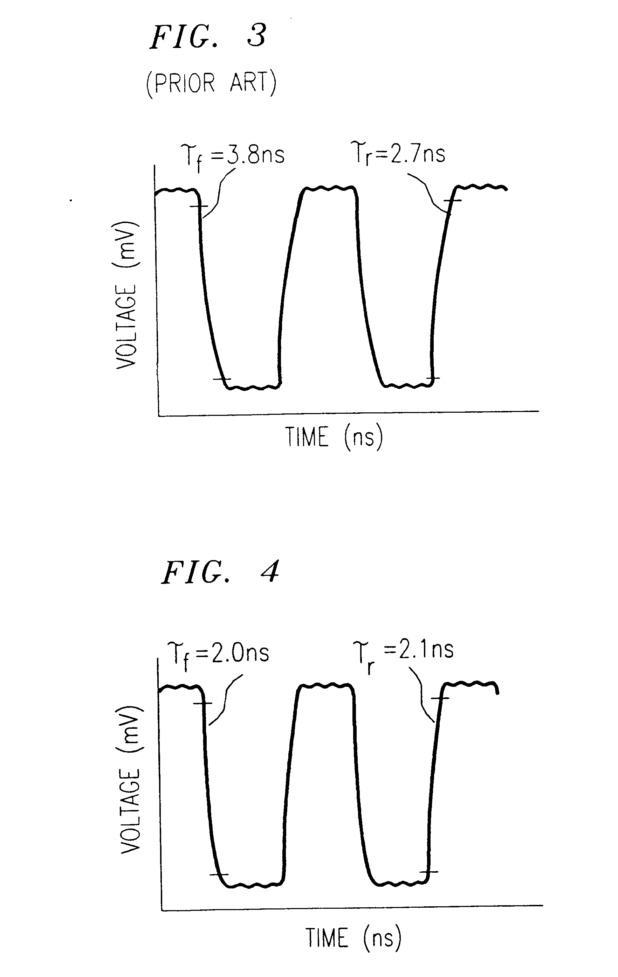

FIG. 3 illustrates an exemplary output pulse of a long wavelength LED. For the illustrated pulse, an InGaAsP LED was coupled to a conventional differential LED driver (such as differential current switch 19 of FIG. 1) with 80 mA of drive current. When operated at a data rate of 125 Mb/s, the LED exhibited a rise time of approximately 2.7 ns and a fall time of approximately 3.8 ns. In contrast, FIG. 4 illustrates an exemplary output pulse of a similar LED when coupled to a switched bridge pulse shaping circuit of the present invention. When operated at the same data rate, with the same drive current during the bit period, the rise time was reduced to 2.1 ns and the fall time to 2.0 ns. In this particular arrangement a delay of 2 ns was utilized between the turn ON of transistors 24,14 and transistor 26.

## Claims

1. An LED driver circuit comprising differential current switching means (12,14,16) for providing a pulse having a predetermined drive current /₂ to the LED, and pulse shaping means for altering the rise and/or fall times of said LED, CHARACTERIZED IN THAT the pulse shaping means comprises first means (20,24) for providing at the beginning of a pulse an increased drive current /1 to the LED, said increased drive current being greater in magnitude than the predetermined drive current so as to provide current peaking and thereby decrease the rise time of said LED, and/or second means (22,26) for providing at the end a pulse a reverse drive current 1₃ through said LED so as to provide charge extraction and thereby decrease the fall time of said LED.

2. A circuit as claimed in claim 1 wherein the first means comprises a first switching means and first resistance means coupled to the LED, and/or the second means comprises a second switching means and second resistance means coupled to the LED.

3. A circuit as claimed in claim 2 wherein the first means comprises a first transistor (20) and a first resistor (24), and/or the second means comprises a second transistor (26) and a second resistor (22).

4. A circuit as defined in claim 3 wherein the or each of said transistors is a bipolar transistor comprising collector, base and emitter regions, the first transistor emitter is coupled to a first terminal of the LED, the collector is coupled to a first power supply and the base is coupled to receive a first activation pulse, and/or the second transistor collector is coupled to said first power supply and the base is coupled to receive a second, delayed activation pulse, the first resistor is coupled between the second transistor emitter and the second, remaining LED terminal, and the second resistor is coupled between the first LED terminal and the differential current switching means.

5. A circuit as claimed in claim 1 wherein the first and/or second means are viable means.

6. A circuit as claimed in claim 5 wherein the first viable means comprises a first switching means (24) and viable resistance means (20), and/or the second viable means comprises a second switching means (26) and viable resistance means (22).
